# EUROPÄISCHE PATENTSCHRIFT

(11) **EP 3 916 236 B1**
(45) Veröffentlichungstag und Bekanntmachung des Hinweises auf die Patenterteilung: **01.03.2023**
(21) Anmeldenummer: 21175726.5
(22) Anmeldetag: 25.05.2021
(51) Int. Cl.: F04D 27/00, F24F 11/62

(54) **VERFAHREN ZUM BETREIBEN EINES VENTILATORSYSTEMS UND VENTILATORSYSTEM MIT EINEM RÜCKWÄRTSGEKRÜMMTEN RADIALVENTILATOR**
METHOD FOR OPERATING A FAN SYSTEM AND FAN SYSTEM WITH A REVERSE CURVED RADIAL FAN
PROCÉDÉ DE FONCTIONNEMENT D'UN SYSTÈME DE VENTILATION ET SYSTÈME DE VENTILATION DOTÉ D'UN VENTILATEUR RADIAL COURBÉ VERS L'ARRIÈRE

(30) Priorität: 28.05.2020 DE 102020114339
(43) Veröffentlichungstag der Anmeldung: 01.12.2021
(73) Patentinhaber: ebm-papst Mulfingen GmbH & Co. KG, 74673 Mulfingen (DE)
(72) Erfinder: EBERLE, Walter, 74673 Mulfingen (DE); WYSTUP, Dr. Ralph, 74653 Künzelsau (DE); HUMM, Markus, 74679 Weißbach (DE); RAU, Alexander, 74076 Heilbronn (DE); NASE, Rainer, 97990 Weikersheim (DE)
(74) Vertreter: Rüger Abel Patentanwälte PartGmbB

(56) Entgegenhaltungen:
- DE-A1-102018 104 396
- DE-U1- 29 516 268
- US-A- 5 736 823
- US-A1- 2017 248 149
- US-A1- 2019 376 715

## Beschreibung

Die Erfindung betrifft ein Verfahren zum Betreiben eines Ventilatorsystems sowie ein solches Ventilatorsystem. Das Ventilatorsystem hat eine Steuereinrichtung und einen rückwärtsgekrümmten Radialventilator. Bei dem rückwärtsgekrümmten Radialventilator sind gekrümmte Ventilatorschaufeln von radial innen nach radial außen schräg zur Radialebene entgegen der Drehrichtung verlaufend angeordnet.

Der Radialventilator hat einen Rotor mit Ventilatorschaufeln sowie einen Motor, der zum Antreiben des Rotors eingerichtet ist.

Die Steuerung bzw. Regelung des Radialventilators soll eine Gasströmung, insbesondere eine Luftströmung, erzeugen. Die Strömung ist durch wenigstens einen Strömungsparameter charakterisiert, der durch einen oder mehrere Strömungsistwerte beschrieben werden kann, wie beispielsweise einen Druck oder einen Volumenstrom. Häufig ist es gewünscht, den Volumenstrom der vom Radialventilator erzeugten Gasströmung zu steuern oder zu regeln.

Wenn kein Sensor zur Messung des Volumenstromes vorhanden ist, besteht bei dem rückwärtsgekrümmten Radialventilator das Problem, dass der Zusammenhang zwischen dem Motorstrom des Motors des Radialventilators und dem erzeugten Volumenstrom nicht in jedem Arbeitspunkt eindeutig ist. Anhand des Motorstroms und anderer Betriebsparameter des Radialventilators kann daher nicht ohne Weiteres auf den erzeugten Volumenstrom geschlossen werden. Außerdem ist eine Regelung des Volumenstroms ohne sensorische Erfassung des Volumenstromistwertes wegen der vielen externen Einfluss- und Störgrößen schwierig.

Es wurden in der Vergangenheit bereits Versuche unternommen, dieses Problem mathematisch bzw. algorithmisch zu lösen, indem der rückwärtsgekrümmte Radialventilator durch ein Modell beschrieben wird und dadurch eine Steuerung basierend auf dem Modell erfolgen kann. Es hat sich allerdings gezeigt, dass das Einstellen eines gewünschten Volumenstroms durch diesen Ansatz relativ ungenau ist.

Weiter sind auch Modellen bekannt die mittels eines künstlichen Neuronalen Netzes einen Volumenstromwert bestimmen, wie es zum Beispiel in der US 2019/376715 A1 offenbart ist.

Ausgehend davon ist es eine Aufgabe der vorliegenden Erfindung ein Verfahren und ein Ventilatorsystem zu schaffen, das ohne die Messung des als Steuer- oder Regelgröße verwendeten Strömungsparameters auskommt und dennoch eine genaue Steuerung oder Regelung ermöglicht.

Die Erfindung wird durch ein Verfahren mit den Merkmalen des Patentanspruches 1 sowie ein Ventilatorsystem mit den Merkmalen des Patentanspruches 16 gelöst.

Das Ventilatorsystem weist eine Steuereinrichtung und einen rückwärtsgekrümmten Radialventilator auf. Der Radialventilator hat einen Motor und einen vom Motor antreibbaren Rotor. Der rückwärtsgekrümmte Radialventilator hat einen Rotor mit Ventilatorschaufeln, die sich gekrümmt schräg zur Radialebene von radial innen nach radial außen erstrecken und dabei eine Erstreckung entgegen der Drehrichtung des Rotors aufweisen. Die radial innere Kante der Ventilatorschaufel ist daher in Drehrichtung betrachtet vor der radial äußeren Kante der Ventilatorschaufel angeordnet. Die in Drehrichtung weisende Seite jeder Ventilatorschaufel ist konvex und die entgegen der Drehrichtung weisende Seite ist konkav ausgebildet.

Bei rotierendem Rotor wird eine Gasströmung erzeugt, die sich durch einen oder mehrere Strömungsparameter bzw. Strömungsistwerte charakterisiert werden kann. Als der wenigstens eine Strömungsistwert kann beispielsweise ein Volumenstromistwert und/oder ein Ausgangsdruckistwert verwendet werden.

Die Steuereinrichtung des Ventilatorsystems weist zur Steuerung oder Regelung des wenigstens einen Strömungsistwertes ein künstliches Neuronales Netz auf. Zur Steuerung oder Regelung des wenigstens einen Strömungsistwertes werden Betriebsparameter des Motors und/oder des Radialventilators verwendet. Ein Betriebsparameter wird durch die Steuereinrichtung als Stellgröße vorgegeben. Zumindest ein Betriebsparameter wird als wenigstens eine Systemistgröße erfasst und kann unmittelbar sensorisch gemessen oder rechnerisch ermittelt werden. Die Stellgröße und die wenigstens eine Systemistgröße sind insbesondere elektrische Betriebsparameter des Motors, wie etwa der Motorstrom, die Motorspannung oder eine Frequenz des Motorstroms oder der Motorspannung.

Ein als Systemistgröße verwendeter Betriebsparameter des Motors kann während des Betriebs kontinuierlich oder zeitdiskret ermittelt werden. Die Systemistgröße kann daher kontinuierlich oder wiederholt zu durch ein Zeitintervall vorgegebenen Zeitpunkten, erfasst werden.

Wenn beispielsweise der Motorstrom oder die Motorspannung geändert wird, reagiert das Ventilatorsystem mit einer Änderung der Systemistgröße, die auch von der Ventilatordrehzahl abhängt. Wird der Motorstrom als Stellgröße eingeprägt, ist die Systemistgröße beispielsweise die Motorspannung. Wenn die Motorspannung als Stellgröße eingeprägt ist, kann als Systemistgröße der Motorstrom verwendet werden.

Die Ventilatordrehzahl und damit die Systemistgröße hängen auch vom Ausgangsdruck bzw. dem Volumenstrom der Gasströmung ab. Denn die Ventilatordrehzahl und insbesondere deren zeitliche Änderung ist auch abhängig vom Ausgangsdruck. Wegen der Kompressibilität des Gases und der damit verbundenen druckabhängigen Dichte und Massenträgheit, sind Änderungen der Ventilatordrehzahl nicht nur abhängig von einer Änderung der Stellgröße, sondern eben auch vom herrschenden Ausgangsdruck. Die druckabhängige Änderung der Ventilatordrehzahl bildet sich im zeitlichen Verlauf der wenigstens einen Systemistgröße ab. Dieser Zusammenhang kann verwendet werden, um das künstliche Neuronale Netz zu trainieren bzw. lernen zu lassen. Die Systemistgröße und die zeitliche Änderung der Systemistgröße sowie die Stellgröße können dem künstlichen Neuronalen Netz übermittelt und verwendet werden, um bei einer Änderung der Systemistgröße eine geänderte Stellgröße zu bestimmen und auszugeben, so dass sich der gewünschte Ausgangsdruck und/oder Volumenstrom der Gasströmung ergibt. Durch das Berücksichtigen der zeitlichen Änderung der Systemistgröße wird die Abhängigkeit zwischen Systemistgröße und Ausgangsdruck und/oder Volumenstrom in ausreichender Auflösung berücksichtigt.

Als Ventilatordrehzahl kann die Drehzahl des Motors oder des die Ventilatorschaufeln tragenden Rotors verwendet werden.

Der die Ventilatorschaufeln tragende Rotor des Radialventilators ist insbesondere drehfest mit dem Rotor des Motors verbunden, so dass die der Motordrehzahl der Rotordrehzahl entspricht.

Mittels des künstlichen Neuronalen Netzes wird wenigstens ein Strömungsistwert der erzeugten Gas- bzw. Luftströmung ermittelt. Die Ermittlung basiert auf den als Stellgröße und als wenigstens eine Systemistgröße verwendeten Betriebsparametern (insbesondere Motorstrom und Motorspannung) sowie der zeitlichen Änderung des Betriebsparameters, der die Systemistgröße bildet. Vorzugsweise wird auch die zeitliche Änderung der Stellgröße an das künstliche Neuronale Netz übermittelt und bei der Regelung oder Steuerung der Gasströmung berücksichtigt.

Durch das Berücksichtigen der zeitlichen Änderung kann auch der Arbeitspunkt ermittelt werden. Beim rückwärtsgekrümmten Radialventilator ist der Zusammenhang zwischen den Betriebsparametern und dem dabei erzeugten Volumenstrom nicht in jedem Arbeitspunkt eindeutig, so dass alleine durch den aktuellen Wert der Stellgröße und der Systemistgröße nicht auf den tatsächlich erzeugten Strömungsistwert geschlossen werden kann. Wird zusätzlich die zeitliche Änderung der Systemistgröße berücksichtigt, ist eine eindeutige Zuordnung möglich. Die Steuerung oder Regelung der erzeugten Gasströmung bzw. Luftströmung ist auf diese Weise ohne die Verwendung eines Strömungssensors, insbesondere Ausgangsdrucksensors bzw. Volumenstromsensors, möglich.

Vorzugsweise wird dem künstlichen Neuronalen Netz der Motorstrom oder die Motorspannung als Stellgröße zugeführt. Außerdem kann dem künstlichen Neuronale Netz die Ventilatordrehzahl oder eine mit der Ventilatordrehzahl zusammenhängende Systemistgröße zugeführt werden, die nicht als Stellgröße verwendet wird, beispielsweise die Motorspannung oder der Motorstrom. Zusätzlich wird dem künstlichen Neuronalen Netz zumindest ein weiterer Wert zugeführt, so dass sich das zeitliche Verhalten der Systemistgröße ermitteln lässt. Dieser weitere Wert kann beispielsweise zumindest ein zeitlich vorangegangener Wert der Systemistgrö-ße oder die zeitliche Ableitung (bevorzugt zumindest die erste zeitliche Ableitung) der Systemistgröße sein. Optional kann dem künstlichen Neuronalen Netz ein weiterer Wert zugeführt werden, so dass sich das zeitliche Verhalten der Stellgröße ermitteln lässt. Dieser weitere Wert kann beispielsweise zumindest ein zeitlich vorangegangener Wert der Stellgröße oder die zeitliche Ableitung (bevorzugt zumindest die erste zeitliche Ableitung) sein.

Durch das künstliche Neuronale Netz können eine Vielzahl von weiteren Parametern berücksichtigt werden, die einen Einfluss auf die erzeugte Gasströmung haben und sich ändern können und die Systemistgröße beeinflussen. Solche Änderungen können durch einen erhöhten Strömungswiderstand in der Anlage entstehen, beispielsweise wenn ein stromaufwärts oder stromabwärts angeordneter Filter, durch den das Gas strömt, zunehmend beladen wird und mithin verstopft. Im Falle der Klimatisierung eines Gebäudes können sich die Strömungseigenschaften beispielsweise auch dadurch ändern, dass die Tür zu einem Raum geöffnet oder geschlossen wird. Allgemein können bei Anlagen analog hierzu Volumenveränderungen im Ansaugvolumen oder Abströmvolumen des Ventilatorsystems einen veränderten Zustand bewirken. Weitere Stör- bzw. Einflussgrößen können Leckagen in einem Strömungskanal, Verstopfungen durch Verschmutzungen in einem Strömungskanal oder dergleichen sein. Auch Änderungen der Umgebungstemperatur, der Umgebungsluftfeuchtigkeit, dem Umgebungsdruck oder anderer Umgebungs- oder Umweltbedingungen haben Einfluss auf die vom Ventilatorsystem erzeugte Gasströmung und lassen sich durch das künstliche Neuronale Netz sehr gut berücksichtigen. Die Komplexität aufgrund der Vielzahl von Einflussparametern lässt sich durch das künstliche Neuronale Netz sehr gut abbilden.

Vor der Inbetriebnahme des Ventilatorsystems kann das künstliche Neuronale Netz basierend auf Expertenwissen und/oder empirisch ermittelten Daten trainiert werden. Das künstliche Neuronale Netz kann in einer Weiterbildung auch dazu eingerichtet sein, am Installationsort trainiert zu werden und zu lernen, wenn weitere Trainingsdaten zur Verfügung stehen. Das künstliche Neuronale Netz kann auch dazu eingerichtet sein aktualisiert zu werden, wenn eine aktuellere Version vorliegt.

Zudem kann das künstliche Neuronale Netz auch in der Lage sein, Veränderungen zu erkennen und anzuzeigen. Beispielsweise können Vergleichsmodelle, die den Zustand des künstlichen Neuronalen Netzes beschreiben, hinterlegt und mit dem aktuellen Zustand des künstlichen Neuronalen Netzes verglichen werden. Daraus kann dann auf die aktuelle Situation bzw. den aktuellen Zustand geschlossen werden, beispielsweise ob ein Filter verstopft ist, eine Tür im Raum offensteht oder dergleichen. Es ist somit auch ein Rückschluss auf eine aktuell vorliegende externe Stör- oder Einflussgröße auf die Steuerung oder Regelung möglich.

Zum Lernen des künstlichen Neuronalen Netzes kann ein gradientenbasierter Lernalgorithmus verwendet werden. Die Größe des künstlichen Neuronalen Netzwerks kann variieren. Das künstliche Neuronale Netzwerk kann beispielsweise eine Eingangsschicht, eine Ausgangsschicht und eine oder mehrere verdeckte Schichten aufweisen. Die Anzahl der Neuronen in jeder Schicht kann gleich oder unterschiedlich groß sein.

Es ist vorteilhaft, wenn die Steuereinrichtung einen Regler aufweist, dem die Regeldifferenz zwischen einem vorgegebenen Strömungssollwert und dem Strömungsistwert übermittelt wird. Der Strömungssollwert kann beispielsweise ein Volumenstromsollwert und der Strömungsistwert ein Volumenstromistwert sein. Der Regler ist dazu eingerichtet, einen oder mehrere Betriebsparameter des Motors abhängig von der Regeldifferenz einzustellen. Der Volumenstrom kann als Regelgröße verwendet werden. Insbesondere ist die Steuerung oder Regelung der Steuereinrichtung dazu eingerichtet, den Volumenstrom konstant zu halten.

Das künstliche Neuronale Netz kann bei einer bevorzugten Ausführungsform wenigstens eine Rückkopplung aufweisen, wobei ein Neuronenausgangswert aus einer Schicht des künstlichen Neuronalen Netzes in eine vorhergehende Schicht als Neuroneneingangswert zurückgeführt wird, insbesondere in die Eingangsschicht. Die Rückkopplung kann innerhalb des künstlichen Neuronalen Netzes oder außerhalb des künstlichen Neuronalen Netzes realisiert sein. Das künstliche Neuronale Netz kann als rekurrentes Neuronales Netz ausgebildet sein. Zum Beispiel kann ein durch das künstliche Neuronale Netz ermittelter Strömungsistwert, wie etwa der Ausgangsdruckistwert und/oder der Volumenstromistwert auf eine vorhergehende Schicht des künstlichen Neuronalen Netzes rückgekoppelt werden, beispielsweise zur Eingangsschicht. Die Rückkopplung dient insbesondere dazu, dass der Zustand des Ventilatorsystems ausreichend stabil gehalten werden kann. Außerdem kann dadurch eine gleitende Mittelwertbildung bei auftretenden Änderungen aufgrund von äußeren Stör- und Einflussgrößen erreicht werden.

Das künstliche Neuronale Netz weist bei einem Ausführungsbeispiel eine Eingangsschicht auf, der der aktuelle Wert der Stellgröße zum aktuellen Zeitpunkt, der aktuelle Wert der Systemistgröße zum aktuellen Zeitpunkt sowie mindestens ein vorangegangener Wert der Systemistgröße - und optional auch der Stellgröße - zu einem vorangegangenen Zeitpunkt übermittelt werden. Wenn ein aktueller Wert zum aktuellen Zeitpunkt und ein vorangegangener Wert zu einem vorangegangenen Zeitpunkt bekannt sind, kann durch Differenzieren die zeitliche Änderung des betreffenden Betriebsparameters (Systemistgröße bzw. Stellgröße) ermittelt werden. Somit können der Eingangsschicht des Neuronalen Netzes beispielsweise die aktuelle Motorspannung, der aktuelle Motorstrom, und wenigstens ein vorangegangener Wert der Motorspannung und/oder des Motorstromes übermittelt werden, um die zeitliche Motorspannungsänderung bzw. Motorstromänderung berücksichtigen zu können. Basierend auf diesen Werten kann das künstliche Neuronale Netz den Volumenstromistwert und/oder den Ausgangsdruckistwert der erzeugten Gasströmung bestimmen.

Bei einer anderen Ausführungsform kann der Eingangsschicht des künstlichen Neuronalen Netzes neben dem aktuellen Wert der Stellgröße zum aktuellen Zeitpunkt und dem aktuellen Wert der wenigstens einen Systemistgröße zum aktuellen Zeitpunkt auch wenigstens eine zeitliche Ableitung der wenigstens einen Systemistgröße und optional zusätzlich auch der Stellgröße übermittelt werden. Beispielsweise kann bei einer kontinuierlichen Messung der wenigstens einen Systemistgröße eine zeitliche Ableitung über ein Differenzierglied durchgeführt und an die Eingangsschicht übergeben werden. Die wenigstens eine zeitliche Ableitung umfasst vorzugsweise zumindest die zeitliche Ableitung erster Ordnung.

Jedes Neuron in jeder Schicht des künstlichen Neuronalen Netzes hat eine vorzugsweise nicht lineare Aktivierungsfunktion. Bei einer bevorzugten Ausführungsform kann die Aktivierungsfunktion durch einen sogenannten Rectifier (abgekürzt: ReLU) gebildet sein. Auch andere Aktivierungsfunktionen können alternativ verwendet werden, beispielsweise eine Schwellenwertfunktion oder eine Sigmoidfunktion.

Es ist vorteilhaft, wenn die Aktivierungsfunktion auf einen Maximalwert begrenzt wird. Dadurch können beispielsweise seltene Merkmale besser trainiert bzw. gelernt werden. Der Maximalwert der Aktivierungsfunktion kann beispielsweise 6 sein.

Vorteilhafte Ausgestaltungen der Erfindung ergeben sich aus den abhängigen Patentansprüchen, der Beschreibung und den Zeichnungen. Nachfolgend werden bevorzugte Ausführungsbeispiele der Erfindung anhand der beigefügten Zeichnungen im Einzelnen erläutert. Es zeigen:
Figur 1 ein stark schematisiertes Blockschaltbild eines Ventilatorsystems mit einer Steuereinrichtung und einem rückwärtsgekrümmten Radialventilator,
Figur 2 ein Blockschaltbild eines künstlichen Neuronalen Netzes der Steuereinrichtung des Ventilatorsystems aus Figur 1,
Figur 3 ein Blockschaltbild eines weiteren Ausführungsbeispiels eines künstlichen Neuronalen Netzes der Steuereinrichtung aus Figur 1,
Figur 4 ein Blockschaltbild eines Neurons des künstlichen Neuronalen Netzwerks der Figuren 1-3,
Figur 5 eine Aktivierungsfunktion für das Neuron aus Figur 4,
Figur 6 einen beispielhaften Zusammenhang zwischen der Volumenströmung, dem Motorstrom und der Ventilatordrehzahl des Ventilatorsystems aus Figur 1, wobei die Linien gleichen Volumenstroms dargestellt sind, die sich mit Linien gleichen Ausgangsdrucks kreuzen,
Figur 7 einen beispielhaften Zusammenhang zwischen der Ventilatordrehzahl, dem Motorstrom und dem Aussteuergrad bzw. der Motorspannung des Ventilatorsystems aus Figur 1,
Figur 8 einen beispielhaften Zusammenhang zwischen der Ventilatordrehzahl, dem Volumenstrom und dem Aussteuergrad bzw. der Spannung des Ventilatorsystems aus Figur 1 und
Figur 9 Kennlinien einer Kennlinienschar, die beispielhaft den Zusammenhang zwischen dem Volumenstrom und dem Motorstrom des Ventilatorsystems aus Figur 1 veranschaulichen.

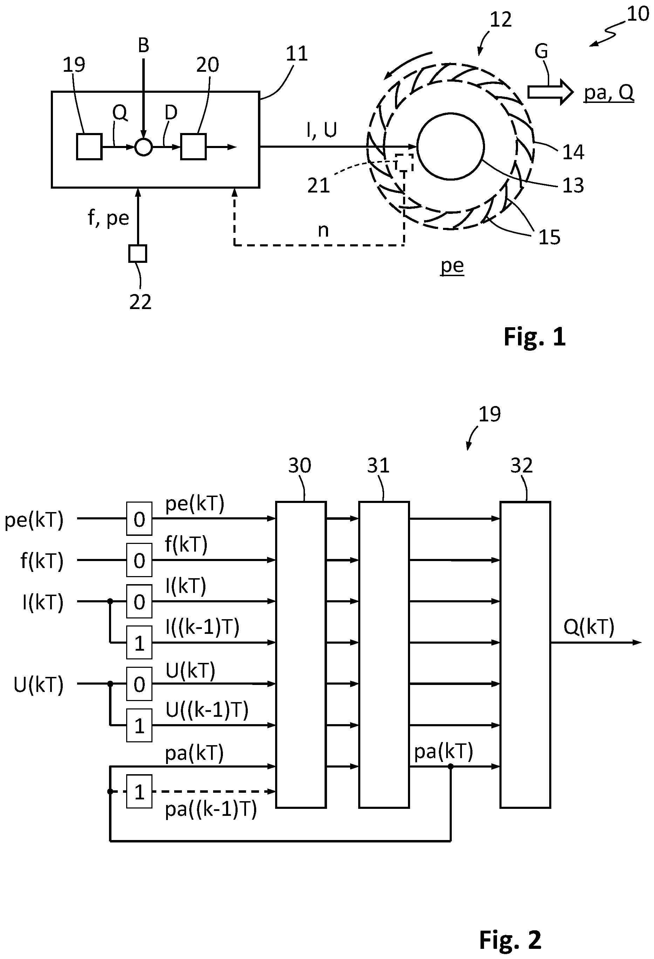

In Figur 1 ist stark schematisiert anhand eines Blockschaltbilds ein Ventilatorsystem 10 veranschaulicht. Das Ventilatorsystem 10 weist eine Steuereinrichtung 11 zur Steuerung oder Regelung eines rückwärtsgekrümmten Radialventilators 12 auf. Der rückwärtsgekrümmte Radialventilator 12 hat einen Motor, beispielsgemäß einen Elektromotor 13, der mit einem Rotor 14 des Radialventilators antriebsverbunden ist. Der Rotor 14 erzeugt bei seiner Drehung eine Gasströmung G, beispielsweise eine Luftströmung, die stromabwärts des Radialventilators 12 bzw. stromabwärts des Ventilatorsystems 10 einen Ausgangsdruck pa und einen Volumenstrom Q aufweist.

Der rückwärtsgekrümmte Radialventilator 12 bzw. der Rotor 14 hat sich zwischen einer radial inneren Kante und einer radial äußeren Kante gekrümmt erstreckende Ventilatorschaufeln 15, die in Drehrichtung regelmäßig verteilt am Rotor 14 angeordnet sind. Die radial innere Kante ist in Drehrichtung betrachtet vor der radial äußeren Kante angeordnet. Die in Drehrichtung weisende Seite jeder Ventilatorschaufel 15 ist konvex und die entgegengesetzte Seite konkav geformt.

Die Gasströmung G kann durch wenigstens einen Strömungsparameter beschrieben werden, beispielsweise durch den Ausgangsdruck pa oder den Volumenstrom Q. Zumindest einer der Strömungsparameter und beispielsgemäß der Volumenstrom Q, kann gesteuert oder geregelt werden. Das Steuern oder Regeln des Strömungswerts der Gasströmung G soll beispielsgemäß ohne sensorische Erfassung erfolgen, insbesondere ohne das Verwenden eines Volumenstromsensors und/oder eines Drucksensors.

Beim Ausführungsbeispiel soll mittels der Steuereinrichtung 11 der Strömungsparameter der Gasströmung G auf einen Wert geregelt werden, der durch einen Strömungssollwert B vorgegeben wird. Der Strömungssollwert B ist beispielsgemäß ein Volumenstromsollwert und der Volumenstrom Q bildet somit die Regelgröße. Der Volumenstromistwert wird nicht sensorisch erfasst, sondern in der Steuereinrichtung 11 unter Verwendung eines künstlichen Neuronalen Netzes 19 ermittelt. Basierend auf dem durch das künstliche Neuronale Netz 19 ermittelten Strömungsistwert, hier dem Volumenstromistwert, kann durch Differenzbildung mit dem Strömungssollwert B eine Regeldifferenz D berechnet und einem Regler 20 der Steuereinrichtung 11 zugeführt werden. Der Regler 20 kann daraufhin einen oder mehrere Betriebsparameter des Elektromotors 13, beispielsweise den Motorstrom I oder die Motorspannung U verändern, um die Regeldifferenz D zu minimieren und idealerweise zu eliminieren.

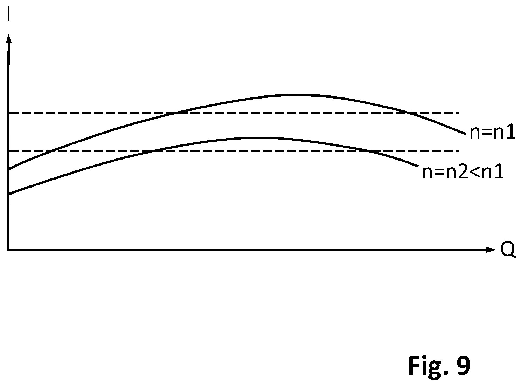

Durch das Profil der Ventilatorschaufeln 15 entsteht eine den Zusammenhang zwischen dem Motorstrom I und dem Volumenstrom Q beschreibende Kennlinie des rückwärtsgekrümmten Radialventilators 12, wie sie in Figur 9 veranschaulicht ist. Der Verlauf ist nicht linear und weist ein Maximum auf. Die Kennlinie verschiebt sich mit zunehmender Ventilatordrehzahl in Richtung höherer Werte des Motorstroms I bei gleichbleibendem Volumenstrom Q. Aufgrund des gekrümmten, parabelähnlichen Verlaufs, kann die Bestimmung des Motorstroms I des Elektromotors 13 und der Ventilatordrehzahl n (Drehzahl des Elektromotors 13 oder Rotors 14) keine eindeutige Zuordnung zu dem erzeugten Volumenstrom Q der Gasströmung G getroffen werden, da der Arbeitspunkt nicht eindeutig ist. Dieser nicht eindeutige Zusammenhang ist durch die jeweils einen konstanten Motorstromwert beschreibenden gestrichelten Linien in Figur 9 veranschaulicht, die jeweils zwei Schnittpunkte mit einer zugeordneten Kennlinie haben.

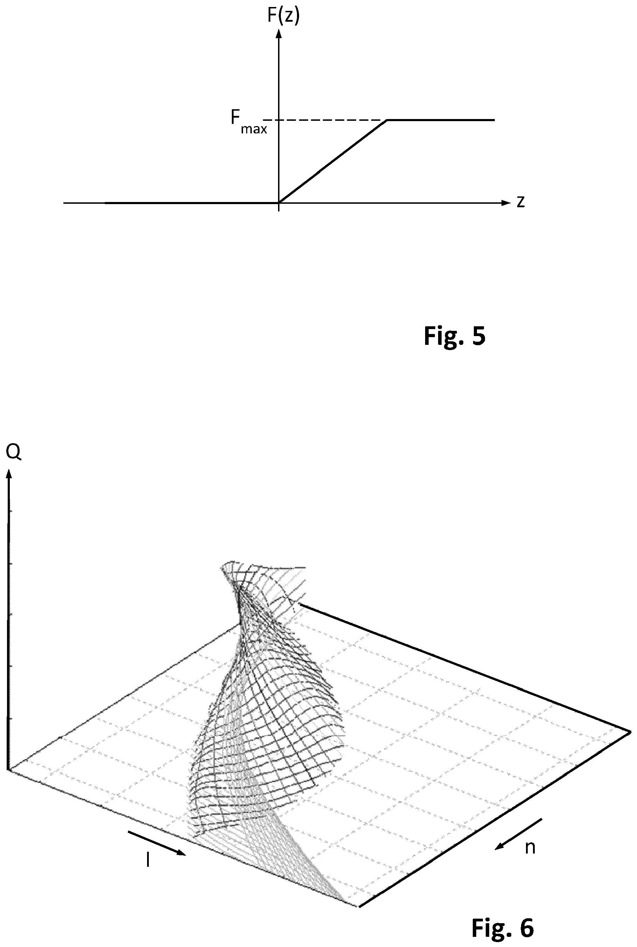

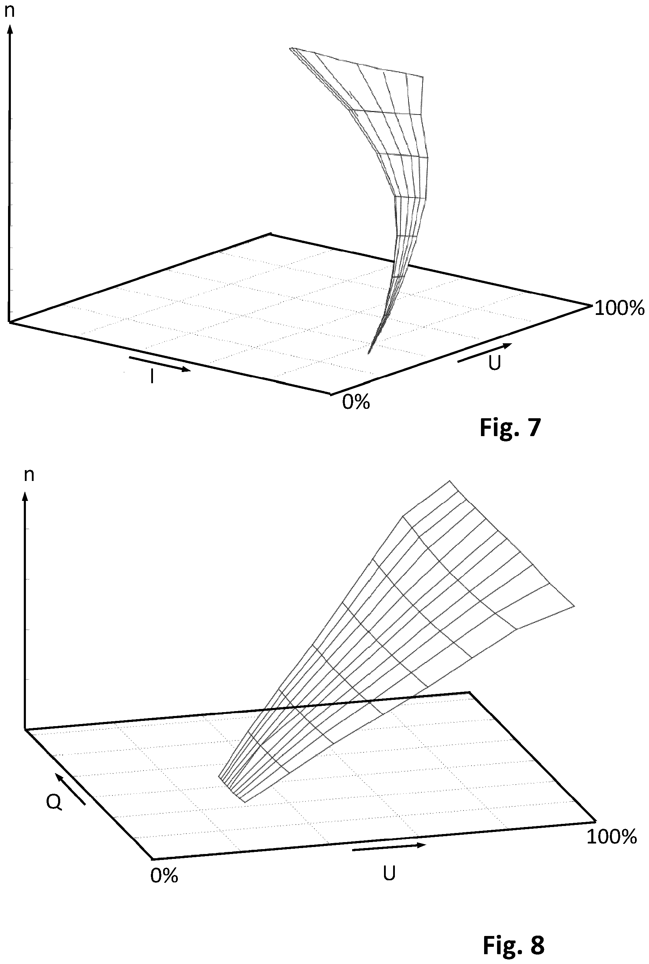

Zur weiteren Veranschaulichung des Betriebsverhaltens des rückwärtsgekrümmten Radialventilators 12 sind in den Figuren 6-8 weitere räumliche Kennflächen veranschaulicht. Figur 6 zeigt den Zusammenhang zwischen dem erzeugten Volumenstrom Q, dem Ausgangsdruck pa, dem Motorstrom I und der Ventilatordrehzahl n. Linien konstanten Ausgangsdrucks pa kreuzen in Figur 6 die Linien konstanten Volumenstroms Q. In Figur 7 ist der Zusammenhang zwischen der Ventilatordrehzahl n, dem Motorstrom I und einer Aussteuerung des Elektromotors 13 zwischen 0% und 100% veranschaulicht, wobei die Aussteuerung mit steigender Motorspannung U zunimmt. Figur 8 veranschaulicht den Zusammenhang zwischen der Ventilatordrehzahl n, dem Volumenstrom Q der Gasströmung G und der Aussteuerung des Elektromotors 13.

Zur Erfassung der Ventilatordrehzahl n kann optional ein Drehzahlsensor 21 vorhanden sein, der vorzugsweise aber entfällt. Optional kann auch wenigstens ein weiterer Sensor 22 vorhanden sein, um die Umgebungsbedingungen oder andere Einflussparameter zu erfassen, beispielsweise die Luftfeuchtigkeit h und/oder den Eingangsdruck pe, der beispielsweise dem Luftdruck in der Umgebung entsprechen kann. Anstelle der sensorischen Erfassung des Eingangsdruckes pe kann dieser auch anderweitig ermittelt werden, beispielsweise durch eine Berechnung abhängig vom geographischen Installationsort des Ventilatorsystems 10, insbesondere der geographischen Höhe über dem Meeresspiegel.

Dem künstlichen Neuronalen Netz 19 werden Betriebsparameter des Radialventilators 12 und insbesondere des Elektromotors 13 übermittelt. Einer der Betriebsparameter bildet eine Stellgröße und ein weiterer Betriebsparameter bildet eine Systemistgröße. Als Stellgröße kann die Motorspannung U und als Systemistgröße der Motorstrom I verwendet werden oder alternativ auch umgekehrt. Diese Systemistgröße kann berechnet, geschätzt oder gemessen werden. Als Motorspannung U kann beispielsweise der mittels der Steuereinrichtung 11 ausgegebene Motorspannungssollwert verwendet werden, so dass auf eine Messung des Motorspannungsistwertes verzichtet werden kann. Die Ventilatordrehzahl n bzw. deren Änderung wird beispielsgemäß indirekt überwacht, z.B. über den Motorstrom I. Alternativ oder zusätzlich kann die Ventilatordrehzahl n auch mittels des Drehzahlsensors 21 sensorisch erfasst und an die Steuereinrichtung 11 übermittelt werden.

Optional können weitere Eingangsgrößen für das künstliche Neuronale Netz 19 der Eingangsdruck pe oder die Luftfeuchtigkeit h sein.

In der Steuereinrichtung 11 bzw. dem künstlichen Neuronalen Netz 19 werden nicht nur lediglich die jeweils aktuellen Werte der Motorspannung U und des Motorstroms I berücksichtigt, sondern auch deren zeitliches Verhalten bzw. zeitlicher Verlauf. Dazu können beispielsweise mehrere zu unterschiedlichen Zeitpunkten erfasste Werte der Motorspannung U und des Motorstroms I als Eingangsgrößen in das künstliche Neuronale Netz 19 eingegeben werden (Figur 2). Die Differenz dieser Werte geteilt durch den zeitlichen Abstand der Erfassung ergibt - zumindest näherungsweise - einen Steigungswert, der die zeitliche Änderung beschreibt.

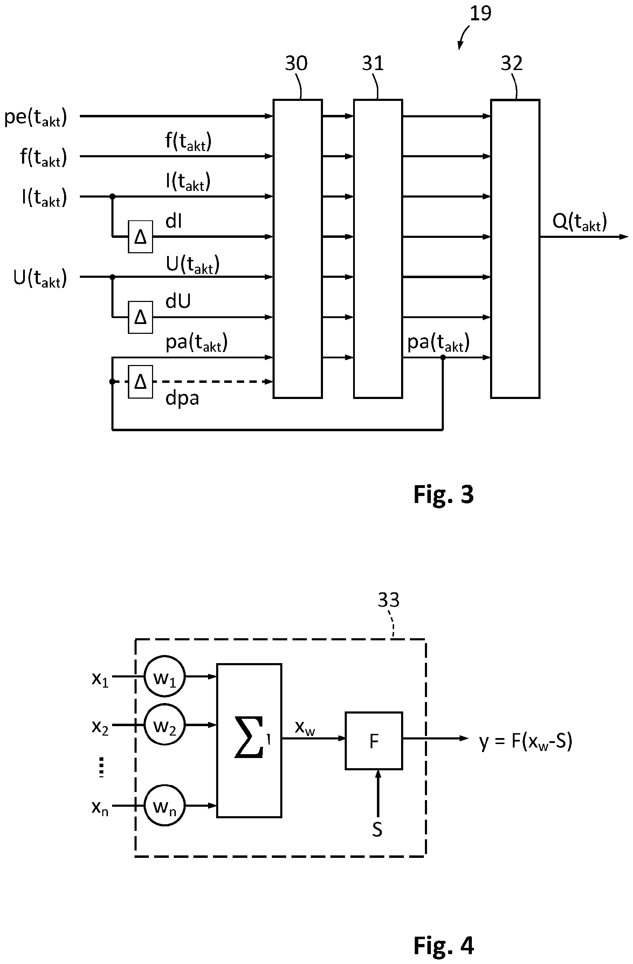

Alternativ kann mit Hilfe von Differenziergliedern 23 eine zeitliche Ableitung erzeugt werden, beispielsweise die Motorstromänderung dI und optional zusätzlich die Ventilatordrehzahländerung dn, die jeweils die zeitlichen Ableitungen erster Ordnung des Motorstroms I bzw. der Ventilatordrehzahl n darstellen (Figur 3). Zusätzlich oder alternativ können auch zeitliche Ableitungen höherer Ordnung ermittelt und berücksichtigt werden. Diese Ausgestaltung eignet sich insbesondere dann, wenn die Betriebsparameter zeitkontinuierlich erfasst werden. In Figur 3 sind die aktuellen Werte durch den aktuellen Messzeitpunkt tₐₖₜ veranschaulicht.

In Figur 2 ist schematisch die Möglichkeit dargestellt, dass die Betriebsparameter zeitdiskret jeweils in einem Zeitintervall T erfasst werden. Der aktuelle Zeitpunkt ist durch das Zeitintervall kT angegeben. Das vorherige Zeitintervall ist beschrieben durch (k-1)T. Für die Eingangsgrößen wird das Zeitverhalten berücksichtig. Der Motorstrom I sowie die Motorspannung U werden jeweils zum aktuellen Zeitintervall als aktueller Motorstromwert I(kT) und als aktueller Motorspannungswert U(kT) an das künstliche Neuronale Netz 19 übergeben. Außerdem werden mindestens ein vorangegangener Motorstrom I((k-1)T) und mindestens ein vorangegangener Motorspannungswert U((k-1)T) an das künstliche Neuronale Netz 19 übergeben, um das Zeitverhalten zu berücksichtigen.

Wie bereits erläutert, können auch weitere Eingangswerte an das künstliche Neuronale Netz übergeben werden, wie es in den Figuren 2 und 3 veranschaulicht ist. Alle Eingangsgrößen können zusätzlich zur Übergabe des jeweils aktuellen Wertes auch im Hinblick auf ihr Zeitverhalten übergeben werden, beispielsweise indem ein vorangegangener Wert zu einem vorangegangenen Zeitpunkt übermittelt wird (Figur 2) oder indem mittels eines Differenziergliedes 23 die zeitliche Ableitung ermittelt wird (Figur 3). In beiden Fällen liegen dem künstlichen Neuronalen Netz 19 Erkenntnisse über das Zeitverhalten vor.

Das künstliche Neuronale Netz 19 ist in den Figuren 2 und 3 lediglich schematisch veranschaulicht. Es weist eine Eingangsschicht 30, wenigstens eine verdeckte Schicht 31 und eine Ausgangsschicht 32 auf. Jeder dieser Schichten 30, 31, 32 des künstlichen Neuronalen Netzes 19 kann abhängig von der konkreten Ausgestaltung eine beliebige Anzahl an Neuronen 33 (Figur 4) aufweisen. In der Eingangsschicht 30 sind beispielsweise so viele Neuronen 33 vorhanden, wie Eingangsgrößen an die Eingangsschicht 30 übermittelt werden. Beim Ausführungsbeispiel ist für jeden aktuellen Wert einer Eingangsgröße ein Neuron 33 vorhanden und für jeden zugeführten vorangegangenen Wert (Figur 2) oder für jede zugeführte zeitliche Ableitung (Figur 3) ist ein zusätzliches Neuron 33 in der Eingangsschicht 30 vorhanden. Beispielsgemäß sind mindestens vier oder fünf Neuronen in der Eingangsschicht 30 vorhanden.

Jedem Neuron 33 in der Eingangsschicht 30 wird zumindest eine der folgenden Eingangsgrößen übermittelt: der aktuelle Wert des Motorstroms I(kT), I(tₐₖₜ) und/oder der aktuelle Wert der Ventilatordrehzahl n(kT), n(tₐₖₜ), der aktuelle Wert der Motorspannung U(kT), U(tₐₖₜ), der aktuelle Wert des Ausgangsdrucks pa, der vorangegangene Wert I((k-1)T) oder die zeitliche Ableitung dI des Motorstroms I und/oder der vorangegangene Wert n((k-1)T) oder die zeitliche Ableitung dn der Ventilatordrehzahl n. Beispielsgemäß wird auch der vorangegangene Wert U((k-1)T) oder die zeitliche Ableitung dU der Motorspannung U an die Eingangsschicht 30 übermittelt. Optional zusätzlich kann auch der vorangegangene Wert pa((k-1)T) des Ausgangsdruckes (Figur 2) oder die zeitliche Ableitung dpa des Ausgangsdruckes pa (Figur 3) an die Eingangsschicht 30 übermittelt werden. Das Zuführen des Eingangsdruckes pe sowie der Luftfeuchtigkeit h ist ebenfalls optional.

Wie es in Figur 4 dargestellt ist, wird jedem Neuron 33 wenigstens ein Wert aus einer anderen Schicht und/oder wenigstens eine der genannten Eingangsgrößen an jeweils einem Neuroneneingang als Neuroneneingangswert x₁ bis xₙ zugeführt. Die Neuroneneingangswerte x₁ bis xₙ werden über jeweils einen zugeordneten Gewichtungsfaktor w₁ bis wₙ gewichtet und aufsummiert, wodurch eine gewichtete Summe x_{w} gebildet wird. Die gewichtete Summe wird einer Aktivierungsfunktion F des Neurons 33 übermittelt. Die Aktivierungsfunktion F hängt auch von einem Schwellenwert S ab. Konkret wird als Neuronenausgangswert y der Wert der Aktivierungsfunktion F ausgegeben, abhängig von der Differenz der gewichteten Summe x_{w} minus dem Schwellenwert S:
y = xw - S. Über den Schwellenwert S wird vorgegeben, wann das Neuron 33 feuert.

Alternativ zu der Berücksichtigung des Schwellenwerts S als Eingangsparameter in der Aktivierungsfunktion F, können auch sogenannte On-Neuronen verwendet werden, bei denen ein Schwellenwert S als Neuroneneingangswert x₀ bei der Bildung der gewichteten Summe x_{w} berücksichtigt wird.

In Figur 5 ist lediglich beispielhaft eine Möglichkeit für eine Aktivierungsfunktion F veranschaulicht. Beispielsgemäß wird als Aktivierungsfunktion F ein Rectifier (ReLU) gewählt. Es können auch andere bekannte Aktivierungsfunktionen für Neuronen 33 verwendet werden, die vorzugsweise nicht linear sind. Beim Ausführungsbeispiel wird der Neuronenausgangswert y auf einen Maximalwert Fₘₐₓ der Aktivierungsfunktion F begrenzt, beispielsweise 6. Durch die Begrenzung auf den Maximalwert können selten auftretende Merkmale beim Lernen des künstlichen Neuronalen Netzes 19 besser berücksichtigt werden.

Das künstliche Neuronale Netz 19 wird anhand bekannter Parameter und Daten trainiert und kann nach dem Training zur Steuerung oder Regelung verwendet werden. Während des Betriebs ist es möglich, das künstliche Neuronale Netz 19 zu aktualisieren. Ein kontinuierliches Lernen ist bei der bevorzugten Ausführung des Ventilatorsystems 10 nicht vorgesehen, da vorzugsweise keine Sensoren 21, 22 vorhanden sind.

Wenigstens ein ermittelter Neuronenausgangswert y kann aus einer nachfolgenden Schicht in eine vorhergehende Schicht zurückgeführt werden. Die Rückkopplung kann intern, innerhalb des künstlichen Neuronalen Netzes 19 oder auch extern, also außerhalb des künstlichen Neuronalen Netzes 19, erfolgen. Das künstliche Neuronale Netz 19 kann beispielsweise als rekurrentes Neuronales Netz ausgestaltet sein. Beispielsgemäß wird in einer verdeckten Schicht 31 oder alternativ auch in der Ausgangsschicht 32 wenigstens ein Strömungsistwert ermittelt, der in eine vorhergehende Schicht zurückgekoppelt werden kann, insbesondere in die Eingangsschicht 30. Bei den in den Figuren 2 und 3 veranschaulichten Ausführungsbeispielen wird innerhalb wenigstens einer verdeckten Schicht 31 ein aktueller Wert für den Ausgangsdruck pa ermittelt und als Eingangsgröße an die Eingangsschicht 30 zurückgekoppelt.

Durch die Rückkopplung des Ausgangsdruckes pa auf die Eingangsschicht 30 ist eine gute Stabilität der Regelung erreicht, auch wenn sich die zugeführten anderen Eingangsgrößen nicht ändern. Außerdem kann unter Verwendung des ermittelten aktuellen Ausgangsdrucks bei der erneuten Berechnung des Ausgangsdrucks eine Mittelwertermittlung erfolgen.

Wenn sich die Strömungsverhältnisse der Gasströmung G aufgrund äußerer Einflüsse ändern, reagiert das Ventilatorsystem mit einer Änderung der Ventilatordrehzahl n, die in der Änderung des Motorstromes I (Systemistgröße) erkannt wird. Das trainierte künstliche Neuronale Netz 19 ermittelt den dazugehörigen Volumenstromistwert des Volumenstroms Q. Der Regler 20 passt daraufhin die Motorspannung U (Stellgröße) an, um die Regeldifferenz D zu minimieren, die wiederum dem künstlichen Neuronale Netz 19 zurückgeführt wird.

Der Regler 20 kann als Softwaremodul und/oder Hardwaremodul realisiert sein. Das Ermitteln der Regeldifferenz und der Stellgröße durch den Regler 20 erfolgt beispielsgemäß außerhalb des künstlichen Neuronalen Netzes 19 und kann optional auch innerhalb des künstlichen Neuronalen Netzes 19 durchgeführt werden.

Beim Trainieren können sehr einfach, beispielsweise unter Verwendung einer Venturi-Düse zur Differenzdruckbestimmung, unterschiedliche Ausgangsdrücke pa eingestellt und das künstliche Neuronale Netz 19 basierend auf dem Wert des Ausgangsdruckes pa gelernt werden, ohne den Volumenstromistwert Q messen zu müssen. Als die Strömungsverhältnisse beschreibender Parameter für das Trainieren bzw. Lernen wird daher nicht der Volumenstrom Q, sondern der Ausgangsdruck pa verwendet, so dass auf einen Volumenstromsensor verzichtet werden kann. Der Einsatz eines Volumenstromsensors beim Training kann im Bedarfsfall erfolgen, um genauere Trainingsergebnisse zu erzielen. Basierend auf diesem Trainieren kann das künstliche Neuronale Netz 19 hinreichend genau an die Anforderungen adaptiert werden, so dass sich bei der Inbetriebnahme gute Regelergebnisse für die Regelung des Volumenstroms Q ergeben.

Das künstliche Neuronale Netz 19 reagiert beim Betrieb des Ventilatorsystems 10 auch auf äußere Veränderungen, die Einfluss auf den Betrieb haben und beispielsweise eine Änderung der Ventilatordrehzahl n erzeugen. In der Steuereinrichtung 11 können Vergleichsmodelle für den Zustand des künstlichen Neuronalen Netzes 19 abgelegt sein, die einer bekannten Störgröße oder einem bekannten Umgebungsparameter zugeordnet sind. Durch Vergleich des aktuellen Zustands des künstlichen Neuronalen Netzes 19 mit den Vergleichsmodellen kann in der Steuereinrichtung 11 somit auch erkannt werden, ob und welche Veränderungen in der Umgebung oder der Anlage eingetreten sind. Beispielsweise kann eine zunehmende Beladung eines Filters bzw. das Verstopfen des Filters erkannt werden. Eine solche Änderung ist im Hinblick auf das zeitliche Verhalten nicht abrupt, sondern langsamer verglichen mit anderen äußeren Einflüssen. Durch die Berücksichtigung der zeitlichen Änderung bzw. zeitlich aufeinanderfolgender Werte zumindest für die Systemistgröße und gegebenenfalls eine oder mehrere weitere Eingangsgrößen im künstlichen Neuronalen Netz 19 lassen sich Rückschlüsse auf die Art des äußeren Einflusses ziehen. Beispielsweise kann das Öffnen oder Schließen einer Tür oder einer Klappe im Ansaugvolumen und/oder im Abströmvolumen durch eine plötzliche Änderung des Betriebszustandes (z.B. der Ventilatordrehzahl n) des Ventilatorsystems 10 erkannt werden.

Aufgrund der Berücksichtigung des Zeitverhaltens, insbesondere des Motorstroms I und/oder der Ventilatordrehzahl n und/oder der Motorspannung U, kann der Arbeitspunkt eindeutig bestimmt und zum Beispiel einem Motorstrom I eindeutig ein aktueller Volumenstrom Q zugeordnet werden. Für die Darstellung in Figur 9 bedeutet dies, dass die Kennlinie aus der Kennlinienschar anhand der aktuellen Ventilatordrehzahl n (gemessen oder berechnet aus Motorstrom I oder Motorspannung U) ausgewählt wird. Anhand der Änderung des Motorstroms I kann erkannt werden, ob der Motorstrom I ansteigt oder fällt. Abhängig davon ist der aktuelle Arbeitspunkt im ansteigenden Teil der Kennlinie bis zum Maximum des Motorstromes I oder im abfallenden Teil der Kennlinie bei Volumenstromwerten, die größer sind als der durch das Maximum des Motorstroms I beschriebene Volumenstromwert.

Die Erfindung betrifft ein Verfahren zum Betreiben eines Ventilatorsystems 10 sowie ein solches Ventilatorsystem 10. Das Ventilatorsystem 10 hat eine Steuereinrichtung 11 mit einem künstlichen Neuronalen Netz 19. Die Steuereinrichtung 11 steuert ein Elektromotor 13 eines rückwärtsgekrümmten Radialventilators 12. Der Radialventilator 12 erzeugt eine Gasströmung G, die durch einen Strömungsistwert, insbesondere den Volumenstromistwert Q, gekennzeichnet ist. Der Strömungsistwert wird nicht sensorisch erfasst, sondern durch das künstliche Neuronale Netz 19 abhängig von Eingangsgrößen durch das künstliche Neuronale Netz 19 ermittelt und basierend darauf wird durch die Steuereinrichtung 11 der Elektromotor 13 gesteuert oder geregelt. Einer Eingangsschicht 30 des künstlichen Neuronalen Netzes 19 werden der Motorstrom I und die Motorspannung U zugeführt sowie deren zeitliche Verhalten, die durch die zeitliche Ableitung (beispielsweise Gradient erster Ordnung) gebildet werden können oder durch wenigstens einen vorangegangenen Wert zu einem früheren, vorangegangenen Zeitpunkt. Es ist insbesondere vorteilhaft, wenn das künstliche Neuronale Netz 19 einen Ausgangsdruckistwert ermittelt und diesen intern oder extern als Eingangsgröße an die Eingangsschicht 30 zurückführt. Weitere Eingangsgrößen können zusätzlich optional berücksichtigt werden.

### Bezugszeichenliste:

- 10: Ventilatorsystem
- 11: Steuereinrichtung
- 12: Radialventilator
- 13: Motor
- 14: Rotor
- 15: Ventilatorschaufel

- 19: künstliches Neuronales Netz
- 20: Regler
- 21: Drehzahlsensor
- 22: Sensor
- 23: Differenzierglied

- 30: Eingangsschicht
- 31: verdeckte Schicht
- 32: Ausgangsschicht
- 33: Neuron

- B: Strömungssollwert
- D: Regeldifferenz
- dI: Motorstromänderung
- dU: Motorspannungsänderung
- dpa: Ausgangsdruckänderung
- F: Aktivierungsfunktion
- Fₘₐₓ: Maximalwert der Aktivierungsfunktion
- G: Gasströmung
- h: Luftfeuchtigkeit
- I: Motorstrom
- kT: aktueller Zeitpunkt (zeitdiskret)
- n: Ventilatordrehzahl
- pa: Ausgangsdruck
- pe: Eingangsdruck
- Q: Volumenstrom
- S: Schwellenwert
- tₐₖₜ: aktueller Zeitpunkt (zeitkontinuierlich)
- U: Motorspannung
- wᵢ: Gewichtungsfaktor i (i=1-n)
- xᵢ: Neuroneneingangswert i (i=1-n)
- x_{w}: gewichtete Summe
- y: Neuronenausgangswert

## Patentansprüche

1. Verfahren zum Betreiben eines Ventilatorsystems (10) aufweisend eine Steuereinrichtung (11) und einen rückwärtsgekrümmten Radialventilator (12) mit einem Motor (13) und einem vom Motor (13) angetriebenen Rotor (14), wobei das Ventilatorsystem (10) dazu eingerichtet ist, eine Gasströmung (G) zu erzeugen, die durch wenigstens einen Strömungsistwert (pa(kT), Q(kT); pa(tₐₖₜ), Q(tₐₖₜ)) charakterisiert ist, wobei das Verfahren umfasst:
- Bestimmen eines den Betriebszustand des Motors (13) des Radialventilators (12) beschreibenden Betriebsparameters (U(kT); U(tₐₖₜ)) als Stellgröße,
- kontinuierliches oder zeitdiskretes Ermitteln wenigstens eines den Betriebszustand des Motors (13) des Radialventilators (12) beschreibenden Betriebsparameters (I(kT); I(tₐₖₜ)) als wenigstens eine Systemistgröße,
- Übergeben der Stellgröße (U(kT); U(tₐₖₜ)) und der Systemistgröße (I(kT); I(tₐₖₜ)) an ein künstliches Neuronales Netz (19) der Steuereinrichtung (11),
- Ermitteln des wenigstens eines Strömungsistwertes (Q(kT), Q(tₐₖₜ)) durch das künstliche Neuronale Netz (19) basierend auf der Stellgröße (U(kT); U(tₐₖₜ)) und der Systemistgröße (I(kT); I(tₐₖₜ)) und der zeitlichen Änderung (I((k-1)T); dI) der Systemistgröße(I((k-1)T); dI),
- Prüfen, ob die Stellgröße (U(kT); U(tₐₖₜ)) verändert werden muss, basierend auf dem wenigstens einen ermittelten Strömungsistwert (Q(kT), Q(tₐₖₜ)).

2. Verfahren nach Anspruch 1, wobei der Steuereinrichtung (11) einen Regler (20) aufweist, dem die Regeldifferenz (D) zwischen einem vorgegebenen Strömungssollwert (B) und dem Strömungsistwert (Q(kT), Q(tₐₖₜ)) übermittelt wird.

3. Verfahren nach Anspruch 1 oder 2, wobei ein Strömungsistwert von dem wenigstens einen im künstlichen Neuronalen Netz (19) ermittelten Strömungsistwert ein Volumenstromistwert (Q(kT), Q(tₐₖₜ)) ist und der Strömungssollwert (B) ein Volumenstromsollwert ist.

4. Verfahren nach Anspruch 2 und 3, wobei sich der Volumenstromsollwert während des Betriebs konstant bleibt, um einen konstanten Volumenstrom zu erhalten.

5. Verfahren nach einem der vorhergehenden Ansprüche, wobei das künstliche Neuronale Netz (19) eine Eingangsschicht (30) aufweist, der der aktuelle Wert der Systemistgröße (I(kT); I(tₐₖₜ)) und der Stellgröße (U(kT); U(tₐₖₜ)) zum aktuellen Zeitpunkt (kT) sowie ein vorangegangener Wert der Systemistgröße (I((k-1)T)) zu einem vorangegangenen Zeitpunkt ((k-1)T) übermittelt werden.

6. Verfahren nach Anspruch 5, wobei der Eingangsschicht (30) zusätzlich ein vorangegangener Wert der Stellgröße (U((k-1)T)) zu einem vorangegangenen Zeitpunkt ((k-1)T) übermittelt wird.

7. Verfahren nach einem der vorhergehenden Ansprüche, wobei das künstliche Neuronale Netz (19) eine Eingangsschicht (30) aufweist, der der aktuelle Wert der Systemistgröße ((I(tₐₖₜ))) zum aktuellen Zeitpunkt (tₐₖₜ) sowie eine zeitliche Änderung der Systemistgröße (dI) zum aktuellen Zeitpunkt (tₐₖₜ) übermittelt werden.

8. Verfahren nach Anspruch 7, wobei der Eingangsschicht (30) zusätzlich eine zeitliche Änderung der Stellgröße (dU) zum aktuellen Zeitpunkt (tₐₖₜ) übermittelt wird.

9. Verfahren nach einem der vorhergehenden Ansprüche, wobei ein Strömungsistwert von dem wenigstens einen im künstlichen Neuronalen Netz (19) ermittelten Strömungsistwert ein Ausgangsdruckistwert (pa(kT), pa(tₐₖₜ)) ist.

10. Verfahren nach einem der vorhergehenden Ansprüche, wobei ein Strömungsistwert (pa(kT), pa(tₐₖₜ)) von dem wenigstens einen im künstlichen Neuronalen Netz (19) ermittelten Strömungsistwert (pa(kT), pa(tₐₖₜ)) zu einer Eingangsschicht (30) des künstlichen Neuronalen Netzes (19) zurückgeführt wird.

11. Verfahren nach Anspruch 9 und 10, wobei der Ausgangsdruckistwert (pa(kT), pa(tₐₖₜ)) zur Eingangsschicht (30) zurückgeführt wird.

12. Verfahren nach einem der vorhergehenden Ansprüche, wobei das künstliche Neuronale Netz (19) Neuronen (33) aufweist und wobei jedes Neuron (33) eine Aktivierungsfunktion (F) aufweist.

13. Verfahren nach Anspruch 12, wobei die Aktivierungsfunktion (F) durch einen Rectifier gebildet.

14. Verfahren nach Anspruch 12 oder 13, wobei die Aktivierungsfunktion (F) auf einen Maximalwert (Fₘₐₓ) begrenzt ist.

15. Verfahren nach einem der vorhergehenden Ansprüche, wobei zumindest eine von der wenigstens einen Systemistgröße von der Ventilatordrehzahl (n) abhängt oder die Ventilatordrehzahl (n) ist und wobei Ventilatordrehzahl (n) indirekt ermittelt oder direkt mittels eines Drehzahlsensors (21) erfasst werden kann.

16. Ventilatorsystem (10) aufweisend eine Steuereinrichtung (11) und einen rückwärtsgekrümmten Radialventilator (12) mit einem Motor (13) und einem vom Motor (13) angetriebenen Rotor (14), wobei die Steuereinrichtung (11) dazu eingerichtet ist, das Verfahren nach einem der vorhergehenden Ansprüche auszuführen.

## Claims

1. Method for operating a fan system (10) comprising a control device (11) and a backward curved centrifugal fan (12) having a motor (13) and a rotor (14) driven by the motor (13), wherein the fan system (10) is configured to create a gas flow (G) that is **characterized by** at least one actual flow value (pa(kT), Q(kT); pa (tₐₖₜ), Q(tₐₖₜ)), wherein the method comprises the following steps:
- Determination of an operation parameter (U(kT); U(tₐₖₜ)) forming a correcting variable and characterizing the operation condition of the motor (13) of the centrifugal fan (12),
- Determination, in a continuous or time-discrete manner, of at least one operation parameter (I(kT); I(tₐₖₜ)) forming at least one actual system variable and characterizing the operation condition of the motor (13) of the centrifugal fan (12),
- Providing the correcting variable (U(kT); U(tₐₖₜ)) and the actual system variable (I(kT); I(tₐₖₜ)) to an artificial neural network (19) of the control device (11),
- Determination of the at least one actual flow value (Q(kT); Q(tₐₖₜ)) by means of the artificial neural network (19) based on the correcting variable (U(kT); U(tₐₖₜ)) and the actual system variable (I(kT); I(tₐₖₜ)) and the time-dependent change (I((k-1)T); dI) of the actual system variable (I((k-1)T);dI),
- Checking whether the correcting variable (U(kT); U(tₐₖₜ)) has to be modified based on the at least one determined actual flow value (Q(kT), Q(tₐₖₜ)).

2. Method according to claim 1, wherein the control device (11) comprises a regulator (20) to which a control deviation (D) between a predefined desired flow value (B) and the actual flow value (Q(kT), Q(tₐₖₜ)) is submitted.

3. Method according to claims 1 or 2, wherein an actual flow value of the at least one actual flow value determined by the artificial neural network (19) is an actual volume flow rate value (Q(kT), Q(tₐₖₜ)) and the desired flow value (B) is a desired volume flow rate value.

4. Method according to claims 2 and 3, wherein the desired volume flow rate value remains constant during operation in order to obtain a constant volume flow rate.

5. Method according to one of the preceding claims, wherein the artificial neural network (19) comprises an input layer (30) to which the actual value of the actual system variable (I(kT); I(tₐₖₜ)) and of the correcting variable (U(kT); U(tₐₖₜ)) for the actual point in time (kT) as well as a preceding value of the actual system variable (I((k-1)T)) to a preceding point in time ((k-1)T) are submitted.

6. Method according to claim 5, wherein in addition a preceding value of the correcting variable (U((k-1)T)) to a preceding point in time ((k-1)T) is submitted to the input layer (30).

7. Method according to one of the preceding claims, wherein the artificial neural network (19) comprises an input layer (30) to which the actual value of the actual system variable ((I(tₐₖₜ)) for the actual point in time as well as a time-dependent change of the actual system variable (dI) for the actual point in time (tₐₖₜ) are submitted.

8. Method according to claim 7, wherein in addition a time-dependent change of the correcting variable (dU) for the actual point in time (tₐₖₜ) is submitted to the input layer (30).

9. Method according to any of the preceding claims, wherein an actual flow value of the at least one actual flow value determined by the artificial neural network (19) is an actual output pressure value (pa(kT), pa(tₐₖₜ)).

10. Method according to any of the preceding claims, wherein an actual flow value (pa(kT), pa(tₐₖₜ)) of the at least one actual flow value (pa(kT), pa(tₐₖₜ)) determined by the artificial neural network (19) is fed back to an input layer (30) of the artificial neural network (19).

11. Method according to claim 9 and 10, wherein the actual output pressure value (pa(kT), pa(tₐₖₜ)) is fed back to the input layer (30).

12. Method according to any of the preceding claims, wherein the artificial neural network (19) comprises neurons (33) and wherein each neuron (33) comprises an activation function (F).

13. Method according to claim 12, wherein the activation function (F) is formed by a rectifier.

14. Method according to claim 12 or 13, wherein the activation function (F) is limited to a maximum value (Fₘₐₓ).

15. Method according to any of the preceding claims, wherein at least one of the at least one actual system variable depends on the fan rotation speed (n) or is the fan rotation speed (n) and wherein the fan rotation speed (n) is determined indirectly or is directly detected by means of a rotation speed sensor (21).

16. Fan system (10) comprising a control device (11) and a backward curved centrifugal fan (12) having a motor (13) and a rotor (14) driven by the motor (13), wherein the control device (11) is configured to carry out the method according to one of the preceding claims.

## Revendications

1. Procédé de fonctionnement d'un système de ventilation (10), présentant un dispositif de commande (11) et un ventilateur radial courbé vers l'arrière (12) doté d'un moteur (13) et d'un rotor (14) entraîné par le moteur (13), le système de ventilation (10) étant conçu pour générer un flux de gaz (G) qui est **caractérisé par** au moins une valeur d'écoulement effective (pa(kT), Q(kT) ; pa(tₐₖₜ), Q(tₐₖₜ)), le procédé comprenant :
- la détermination d'un paramètre de fonctionnement (U(kT) ; U(tₐₖₜ)) décrivant l'état de fonctionnement du moteur (13) du ventilateur radial (12), en tant que grandeur réglante,
- la détermination continue ou à temps discret d'au moins un paramètre de fonctionnement (I(kT) ; I(tₐₖₜ)) décrivant l'état de fonctionnement du moteur (13) du ventilateur radial (12), en tant que grandeur effective du système, au nombre d'au moins une,
- la transmission de la grandeur réglante (U(kT) ; U(tₐₖₜ)) et de la grandeur effective du système (I(kT) ; I(tₐₖₜ)) à un réseau de neurones artificiels (19) du dispositif de commande (11),
- la détermination de la valeur d'écoulement effective (Q(kT), Q(tₐₖₜ)), au nombre d'au moins une, par le réseau de neurones artificiels (19), sur la base de la grandeur réglante (U(kT) ; U(tₐₖₜ)) et de la grandeur effective du système (I(kT) ; I(tₐₖₜ)) et de la variation dans le temps (I((k-1)T) ; dI) de la grandeur effective du système (I((k-1)T) ; dI),
- la vérification pour savoir si la grandeur réglante (U(kT) ; U(tₐₖₜ)) doit être modifiée, sur la base de la grandeur effective du système (Q(kT) ; Q(tₐₖₜ) déterminée, au nombre d'au moins une.

2. Procédé selon la revendication 1, selon lequel le dispositif de commande (11) présente un régulateur (20) auquel est transmise la différence de régulation (D) entre une valeur d'écoulement de consigne (B) prédéfinie et la valeur d'écoulement effective (Q(kT), Q(tₐₖₜ)).

3. Procédé selon la revendication 1 ou 2, selon lequel une valeur d'écoulement effective parmi la valeur d'écoulement effective, au nombre d'au moins une, déterminée dans le réseau de neurones artificiels (19), est une valeur effective de débit volumique (Q(kT), Q(tₐₖₜ)), et la valeur d'écoulement de consigne (B) est une valeur de consigne de débit volumique.

4. Procédé selon les revendications 2 et 3, selon lequel la valeur de consigne de débit volumique reste constante pendant le fonctionnement, afin d'obtenir un débit volumique constant.

5. Procédé selon l'une des revendications précédentes, selon lequel le réseau de neurones artificiels (19) présente une couche d'entrée (30) à laquelle sont transmises la valeur actuelle de la grandeur effective du système (I(kT) ; I(tₐₖₜ)) et de la grandeur réglante (U(kT) ; U(tₐₖₜ)), à l'instant actuel (kT), ainsi qu'une valeur précédente de la grandeur effective du système (I((k-1)T)), à un instant précédent ((k-1)T).

6. Procédé selon la revendication 5, selon lequel est transmise en outre à la couche d'entrée (30), une valeur précédente de la grandeur réglante (U((k-1)T)), à un instant précédent ((k-1)T).

7. Procédé selon l'une des revendications précédentes, selon lequel le réseau de neurones artificiels (19) présente une couche d'entrée (30) à laquelle sont transmises la valeur actuelle de la grandeur effective du système ((I(tₐₖₜ))), à l'instant actuel (tₐₖₜ), ainsi qu'une variation dans le temps de la grandeur effective du système (dI), à l'instant actuel (tₐₖₜ).

8. Procédé selon la revendication 7, selon lequel est transmise en outre à la couche d'entrée (30), une variation dans le temps de la grandeur réglante (dU), à l'instant actuel (tₐₖₜ).

9. Procédé selon l'une des revendications précédentes, selon lequel une valeur d'écoulement effective parmi la valeur d'écoulement effective, au nombre d'au moins une, déterminée dans le réseau de neurones artificiels (19), est une valeur effective de pression de sortie (pa(kT), pa(tₐₖₜ)).

10. Procédé selon l'une des revendications précédentes, selon lequel une valeur d'écoulement effective (pa(kT), pa(tₐₖₜ)) parmi la valeur d'écoulement effective (pa(kT), pa(tₐₖₜ)), au nombre d'au moins une, déterminée dans le réseau de neurones artificiels (19), est ramenée à une couche d'entrée (30) du réseau de neurones artificiels (19).

11. Procédé selon les revendications 9 et 10, selon lequel la valeur effective de pression de sortie (pa(kT), pa(tₐₖₜ)) est ramenée à la couche d'entrée (30).

12. Procédé selon l'une des revendications précédentes, selon lequel le réseau de neurones artificiels (19) présente des neurones (33), et chaque neurone (33) présente une fonction d'activation (F).

13. Procédé selon la revendication 12, selon lequel la fonction d'activation (F) est établie par un rectifieur.

14. Procédé selon la revendication 12 ou 13, selon lequel la fonction d'activation (F) est limitée à une valeur maximale (Fₘₐₓ)

15. Procédé selon l'une des revendications précédentes, selon lequel au moins une des grandeurs effectives du système, au nombre d'au moins une, dépend de la vitesse de rotation du ventilateur (n) ou est la vitesse de rotation du ventilateur (n), et selon lequel la vitesse de rotation du ventilateur (n) peut être déterminée de manière indirecte ou peut être recueillie de manière directe, à l'aide d'un capteur de vitesse de rotation (21).

16. Système de ventilation (10), présentant un dispositif de commande (11) et un ventilateur radial courbé vers l'arrière (12) doté d'un moteur (13) et d'un rotor (14) entraîné par le moteur (13), le dispositif de commande (11) étant conçu pour mettre en oeuvre le procédé selon l'une des revendications précédentes.
